# EUROPEAN PATENT APPLICATION

(11) **EP 4 834 165 A1**
(43) Date of publication of application: **04.11.2026**
(21) Application number: 25173710.2
(22) Date of filing: 30.04.2025
(51) Int. Cl.: A44B 19/42, C23C 14/16, A44B 19/06, B22F 3/22, C23C 14/06

(54) **TOOTH FOR ZIPPER PRODUCED BY MIM AND OPTIMIZED FOR PVD**

(71) Applicant: Metelier SA, 6900 Lugano Paradiso (CH)
(72) Inventor: Minozzi, Rizzardo, 6900 Gentilino (CH)

(57) **Abstract**

The invention relates to a tooth for a zipper, produced by metal injection molding (MIM) and specifically designed to be coated with a physical vapor deposition (PVD) layer. The tooth body is made of stainless steel and features a geometry optimized for precise interlocking with adjacent teeth. The invention eliminates the need for galvanic pretreatment, allowing direct adhesion of the PVD layer to the sintered metal surface. The resulting component exhibits superior mechanical strength, aesthetic quality, corrosion resistance, and is environmentally compliant. The invention also covers a method for producing such a tooth and its integration into a full zipper system composed of MIM components.

## Description

### Field of the Invention:

The present invention relates to a component for zippers, specifically a tooth manufactured using Metal Injection Molding (MIM) technology and designed to be treated with Physical Vapor Deposition (PVD) coatings to improve its aesthetic, mechanical, and environmental performance.

### Background of the Invention:

Currently, high-end zippers use teeth made of brass or brass-like alloys (e.g., tombak), typically processed by stamping or die-casting. These require galvanic treatments to obtain the aesthetic finishes required in luxury and fashion industries.

Such traditional methods face significant limitations:
- Low wear resistance
- Environmental concerns due to galvanic processes
- Poor PVD compatibility
- Regulatory pressure to eliminate hazardous substances like nickel

### Objective of the Invention:

The goal of this invention is to introduce a new type of zipper tooth which:
- Is produced with stainless steels or high-performance sinterable metal alloys via MIM
- Offers micrometric tolerances for reliable interlocking
- Is directly compatible with PVD coatings without galvanic underlayers
- Guarantees high mechanical, chemical, and environmental resistance
- Represents a sustainable alternative to conventional brass-based solutions

### Detailed Description:

The invention comprises a zipper tooth made from a compact metallic body, manufactured using MIM. The preferred materials are stainless steel alloys such as AISI 316L, 17-4PH, or AISI 440C.

The process includes:
1. Mixing metal powder with thermoplastic binder
2. High-precision injection into a mold
3. Thermal or catalytic debinding to remove binder
4. Sintering under controlled atmosphere to produce a dense, functional part

### Performance and Compatibility:

The resulting tooth features:
- Dimensional tolerance: ±0.03 mm
- Surface roughness after sintering: Ra 0.3-0.5 µm
- Geometry optimized to maintain interlock precision
- Enhanced surface for direct PVD adhesion (no galvanic base needed)
- Typical PVD coatings: TiN (gold), CrN (black), ZrN (champagne)
- Coating thickness: 0.2-1.0 µm
- Final surface hardness (TiN): ≥2000 HV
- PVD adhesion rating: ASTM D3359 - Classification 5B
- Salt spray resistance: >200 hours (ASTM B117)
- Functional durability: >10,000 open/close cycles with no degradation

### Applications:

The described tooth can be used in luxury leather goods, high-end apparel and footwear, and technical garments (e.g., outdoor, automotive, yachting). It can be integrated into a complete zipper chain made entirely of MIM components, including sliders, pullers, and top/bottom stops, ensuring performance, consistency, and 100% nickel-free certification.

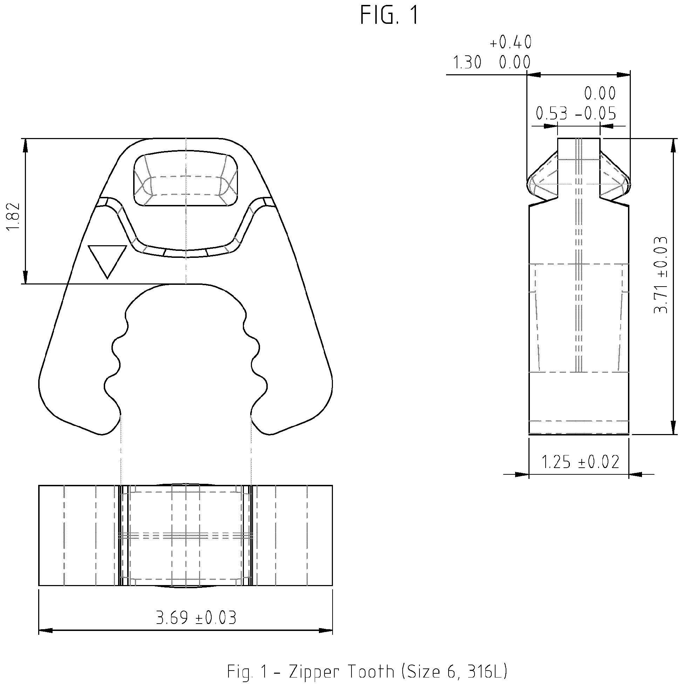

## Claims

1. A tooth for a zipper, comprising:
- a body made of metal produced by metal injection molding (MIM),
- said body having a geometry adapted to ensure mechanical interlocking with adjacent teeth,
- said body being made of a stainless steel alloy,
- wherein the outer surface of the tooth is coated with a physical vapor deposition (PVD) layer directly adhered to the sintered surface,
- and wherein no galvanic intermediate coating is present between the PVD layer and the sintered metal.

2. The tooth of claim 1, wherein the stainless steel alloy is selected from the group consisting of AISI 316L, AISI 440C, and 17-4PH.

3. The tooth of claim 1, wherein the dimensional tolerance after sintering is ±0.03 mm.

4. The tooth of claim 1, wherein the surface roughness (Ra) of the sintered body is between 0.3 µm and 0.5 µm.

5. The tooth of claim 1, wherein the PVD layer comprises TiN, CrN, or ZrN.

6. The tooth of claim 1, wherein the PVD layer has a thickness between 0.2 µm and 1.0 µm.

7. The tooth of claim 1, wherein the coated surface exhibits a Vickers hardness of at least 2000 HV.

8. The tooth of claim 1, wherein the adhesion of the PVD coating complies with classification 5B according to ASTM D3359.

9. The tooth of claim 1, wherein the coated tooth resists corrosion in a salt spray chamber for more than 200 hours according to ASTM B117.

10. The tooth of claim 1, wherein the coated tooth is capable of withstanding over 10,000 cycles of opening and closing without surface degradation.

11. A zipper chain comprising a plurality of teeth according to any of claims 1 to 10, assembled with components manufactured by MIM technology including sliders, pullers, top stops, and bottom stops.

12. A method of manufacturing a zipper tooth as in claim 1, comprising the steps of:
- preparing a feedstock of stainless steel powder and binder,
- injecting the feedstock into a mold to form a green part,
- performing debinding and sintering to form a metal tooth,
- and applying a PVD coating directly to the sintered surface.

## Amended claims

### Amended claims in accordance with Rule 137(2) EPC.

1. lA zipper tooth produced by metal injection molding (MIM) from a stainless-steel feedstock; after sintering, the tooth has a surface roughness Ra of 0.3-0.5 µm and dimensional tolerance ±0.03 mm; a PVD coating selected from TiN, CrN or ZrN, of 0.2-1.0 µm thickness, is directly adhered to the sintered surface without any galvanic intermediate layer; the coated tooth exhibits adhesion 5B (ASTM D3359), Vickers hardness ≥ 2000 HV, salt-spray resistance > 200 h (ASTM B117), and withstands > 10 000 open/close cycles without surface degradation.

2. The tooth of claim 1, wherein the stainless steel alloy is selected from the group consisting of AISI 316L, AISI 440C, and 17-4PH.

3. The tooth of claim 1, wherein the dimensional tolerance after sintering is ±0.03 mm.

4. The tooth of claim 1, wherein the surface roughness (Ra) of the sintered body is between 0.3 µm and 0.5 µm.

5. The tooth of claim 1, wherein the PVD layer comprises TiN, CrN, or ZrN.

6. The tooth of claim 1, wherein the PVD layer has a thickness between 0.2 µm and 1.0 µm.

7. The tooth of claim 1, wherein the coated surface exhibits a Vickers hardness of at least 2000 HV.

8. The tooth of claim 1, wherein the adhesion of the PVD coating complies with classification 5B according to ASTM D3359.

9. The tooth of claim 1, wherein the coated tooth resists corrosion in a salt spray chamber for more than 200 hours according to ASTM B117.

10. The tooth of claim 1, wherein the coated tooth is capable of withstanding over 10 000 cycles of opening and closing without surface degradation.

11. A zipper chain comprising a plurality of teeth according to any of claims 1 to 10, assembled with components manufactured by MIM technology including sliders, pullers, top stops, and bottom stops.

12. A method of manufacturing a zipper tooth as in claim 1, comprising the steps of: preparing a feedstock of stainless-steel powder and a thermoplastic binder; injecting the heated feedstock under pressure into a mold cavity to form a green part; performing debinding and sintering to obtain a dense metal tooth; and then either polishing the sintered surface (optional) or applying a PVD coating directly as per the features of claim 1.
